# FASCICULE DE BREVET EUROPEEN

(11) **EP 1 968 103 B1**
(45) Date de publication et mention de la délivrance du brevet: **14.09.2016**
(21) Numéro de dépôt: 08354017.9
(22) Date de dépôt: 28.02.2008
(51) Int. Cl.: H01L 29/10, H01L 21/84, H01L 21/8238, H01L 21/02

(54) **Procédé de fabrication d'un substrat mixte et utilisation du substrat pour la réalisation de circuits CMOS**
Verfahren zur Herstellung eines Mischsubstrats und Verwendung für die Herstellung von CMOS-Schaltungen
Method for manufacturing a mixed substrate and use of the substrate to make CMOS circuits

(30) Priorité: 05.03.2007 FR 0701587
(43) Date de publication de la demande: 10.09.2008
(73) Titulaire: Commissariat à l'Énergie Atomique et aux Énergies Alternatives, 75015 Paris (FR)
(72) Inventeur: Clavelier, Laurent, 38000 Grenoble (FR); Le Royer, Cyrille, 38000 Grenoble (FR); Damlencourt, Jean-François, 38120 Saint-Egreve (FR)
(74) Mandataire: Hecké, Gérard

(56) Documents cités:
- WO-A-2006/043471
- WO-A-2006/090201
- US-A1- 2004 256 700

## Description

### Domaine technique de l'invention

L'invention concerne un procédé de fabrication d'un substrat mixte comportant au moins une portion en silicium sur isolant contraint en tension et au moins une portion en germanium sur isolant contraint en compression.

L'invention concerne également l'utilisation d'un substrat obtenu par un tel procédé de fabrication pour la réalisation de circuits CMOS comportant au moins un composant N-MOS réalisé sur la portion en silicium sur isolant contraint en tension du substrat et au moins un composant P-MOS réalisé sur la portion en germanium sur isolant contraint en compression du substrat.

### État de la technique

La course aux performances (niveau de courant, vitesse, etc.) en microélectronique à base de silicium pousse notamment à miniaturiser de plus en plus la taille des transistors. En parallèle avec ce phénomène de miniaturisation, il a été proposé des approches d'introduction de nouveaux matériaux, notamment des matériaux à forte mobilité comme le germanium, et des approches d'introduction de contraintes mécaniques, une contrainte en tension favorisant le transport électronique et une contrainte en compression favorisant le transport par trous, dans le cas du silicium et du germanium.

Les éléments de base de la microélectronique CMOS (« Complementary Metal Oxide Semiconductor » en anglais) sont le transistor de type N-MOS, c'est-à-dire un transistor à conduction par électrons, et le transistor de type P-MOS, c'est-à-dire un transistor à conduction par trous. Ces deux types de transistors sont généralement associés pour réaliser des fonctions logiques, par exemple des portes OR, AND, NOR, NAND, etc., ou des points mémoire, par exemple SRAM-6T. Aujourd'hui, la totalité des composants pour la microélectronique « grand public » sont faits sur des substrats en silicium.

Du fait du ratio des mobilités volumiques entre électrons et trous dans le silicium, respectivement 1500cm²/V/s et 500mc²/V/s, les caractéristiques électriques des transistors N-MOS et P-MOS présentent des dissymétries et les transistors P-MOS sont beaucoup moins performants que les transistors N-MOS, en termes notamment de courant débité et de vitesse.

La co-intégration d'un transistor N-MOS en silicium et d'un transistor P-MOS en germanium sur un même substrat est un moyen d'améliorer les caractéristiques du transistor P-MOS dans le circuit CMOS, mais aussi d'équilibrer les transistors de type N et de type P, tant en termes de niveau de courant qu'en termes de constantes de temps, et ceci sans perte de place. En effet, la mobilité volumique des trous dans le germanium est de l'ordre de 1900cm²/V/s et celle des électrons dans le silicium est voisine de 1500cm²/V/s. Il est ainsi possible de fabriquer des transistors de type N et de type P de mêmes dimensions, ayant quasiment les mêmes caractéristiques électriques.

Pour la réalisation de tels transistors, la technique de fabrication par enrichissement en germanium a largement été décrite, notamment dans les articles « Ultra-thin body SiGe-on-Insulator p-MOSFETs with high mobility SiGe surface channels » de T. Tezuka et al. (EDL 2002, vol. 50, N°5, pp 1328-1333, 2003) et « Characterization of 7-nm-thick strained Ge-on-insulator layer fabricated by Ge-condensation technique » de Nakaharai et al. (Applied Physics Letters, Volume 83, Number 17, 2003).

Cependant, la fabrication d'un substrat en germanium sur isolant GeOl, c'est-à-dire toute couche en Si_{1-X}Ge_{X}Ol, avec la concentration X de germanium supérieure ou égale à 0,8, par la technique d'enrichissement en germanium passe par la réalisation d'une préstructure formée d'une couche en Si_{1-X}Ge_{X}, déposée sur un substrat en silicium sur isolant SOI. Plus le substrat va être enrichi en germanium, plus il va exister un désaccord de maille entre la couche en alliage de silicium et germanium enrichie et la couche sous-jacente de silicium du substrat en silicium sur isolant SOI. La relaxation de la contrainte de la couche enrichie ne sera pas observée, tant que la couche enrichie n'aura pas dépassé une certaine épaisseur, appelée « épaisseur critique de relaxation plastique ». Au-delà de cette épaisseur, la couche relaxe progressivement sa contrainte par création de défauts structuraux de type dislocations. Par ailleurs, l'épaisseur critique de relaxation plastique est d'autant plus faible que la concentration en germanium de la couche Si_{1-X}Ge_{X} enrichie est élevée. La technique d'enrichissement en germanium sur substrat en silicium sur isolant SOI présente donc une limitation technique, à savoir la relaxation des contraintes et l'apparition de défauts au cours de l'enrichissement.

Pour remédier aux inconvénients ci-dessus, il a été proposé d'utiliser des substrats en silicium sur isolant contraint (sSOl) (« strained Silicon On Insulator » en anglais). Ces substrats sont des substrats en silicium sur isolant (SOI), dont la membrane supérieure en silicium est contrainte en tension par modification de son paramètre de maille.

Plus particulièrement, l'idée et l'intérêt de réaliser des transistors de type N-MOS sur du silicium contraint en tension et des transistors de type P-MOS sur du germanium contraint en compression ont déjà été proposés et décrits, notamment dans l'article « Strained-SOl SGOI Dual Channel CMOS Technology Based on Ge Condensation Technique » de T. Tezuka et al. (Third International SiGe Technology and Device Meeting (ISTDM), 2006). L'article décrit une technique utilisant un procédé d'enrichissement en germanium, pour réaliser une co-intégration de silicium sur isolant (SOI) et germanium sur isolant (GeOl), pour réaliser respectivement des composants N-MOS et des composants P-MOS.

Cependant, le substrat de départ dans le procédé ci-dessus est un substrat en silicium et germanium sur isolant (SiGeOl) relaxé, qui, à certains endroits, est enrichi en germanium jusqu'à obtenir du germanium sur isolant (GeOl). La conservation de la contrainte mécanique n'est donc pas assurée dans cette approche. De plus, les zones en silicium dédiées à la réalisation de composants N-MOS sont obtenues par épitaxie de silicium sur le substrat en silicium et germanium sur isolant (SiGeOl) de départ. Cette approche ne permet donc pas d'avoir les deux canaux de germanium et silicium sur un même plan et ne permet donc pas d'avoir des couches de silicium très minces, notamment intéressantes pour les technologies « Fully Depleted » dans le but de réduire les effets de canaux courts.

Par ailleurs, dans l'article « Strained Si and Ge MOSFETs with High-K/Metal Gate Stack for High Mobility Dual Channel CMOS » de O. Weber et al. (IEDM Tech. Digest, pp. 143-146, 2005), il a été proposé une autre technique de réalisation d'un substrat utilisant un substrat en silicium sur isolant contraint ou un pseudo substrat en alliage de silicium et germanium relaxé à 50%, c'est-à-dire avec un dépôt par épitaxie d'une couche très épaisse en alliage de silicium et germanium sur une plaque de silicium, pour réaliser ensuite soit des zones épitaxiales de silicium, en vue de la fabrication des composants de type N-MOS, soit des zones épitaxiales de germanium, en vue de la fabrication des composants de type P-MOS.

Cependant, une telle technique ne permet pas de réaliser un circuit CMOS présentant des caractéristiques optimales, car les composants N-MOS et P-MOS sont notamment réalisés sur des zones en silicium contraint et en germanium contraint obtenues par hétéroépitaxie. De telles zones ne sont donc pas « sur isolant » et sur film mince, ce qui ne permet pas de garantir un contrôle électrostatique des composants réalisés par la suite.

Le document WO2006/043471, publié le 27 Avril 2006 (voir aussi le document EP 1811548), décrit une méthode de fabrication d'une couche en SiGe relaxée. Cette méthode comprend un traitement thermique sous atmosphère oxydante pour enrichir en Ge la couche en SiGe et un traitement thermique sous atmosphère non-oxydante pour relâcher les contraintes.

### Objet de l'invention

L'invention a pour but de remédier à l'ensemble des inconvénients précités et a pour objet la réalisation d'un procédé de fabrication d'un substrat mixte, qui permette d'induire une contrainte en tension sur une portion en silicium sur isolant du substrat et une contrainte en compression sur une portion en germanium sur isolant du substrat, et qui soit simple à réaliser, tout en réduisant au maximum les taux de défauts du substrat.

Selon l'invention, ce but est atteint par le fait que le procédé comporte, après la réalisation du substrat de base en silicium sur isolant contraint, les étapes successives suivantes de :
- masquage de la première zone en silicium contraint en tension du substrat de base, formant la portion en silicium sur isolant contraint en tension du substrat,
- traitement d'enrichissement en germanium de la seconde zone en silicium contraint en tension du substrat de base, jusqu'à obtenir ladite portion en germanium sur isolant contraint en compression du substrat,
- élimination du masquage.

L'invention a également pour objet l'utilisation d'un substrat mixte obtenu par un tel procédé de fabrication pour la réalisation de circuits CMOS, comportant au moins un composant N-MOS réalisé sur la portion en silicium sur isolant contraint en tension du substrat et au moins un composant P-MOS réalisé sur la portion en germanium sur isolant contraint en compression du substrat.

### Description sommaire des dessins

D'autres avantages et caractéristiques ressortiront plus clairement de la description qui va suivre d'un mode particulier de réalisation de l'invention donné à titre d'exemple non limitatif et représenté aux dessins annexés, dans lesquels :
Les figures 1 à 4 représentent schématiquement différentes étapes successives d'un mode particulier de réalisation d'un procédé de fabrication d'un substrat mixte selon l'invention.
La figure 5 est un graphique illustrant l'évolution de la concentration en germanium en fonction du temps d'une couche en alliage de silicium et germanium, au cours d'une étape d'enrichissement en germanium, pour obtenir une portion du substrat selon les figures 1 à 4.
La figure 6 est un graphique illustrant l'évolution de la contrainte correspondante en fonction du temps, de la couche en alliage de silicium et germanium selon la figure 5.

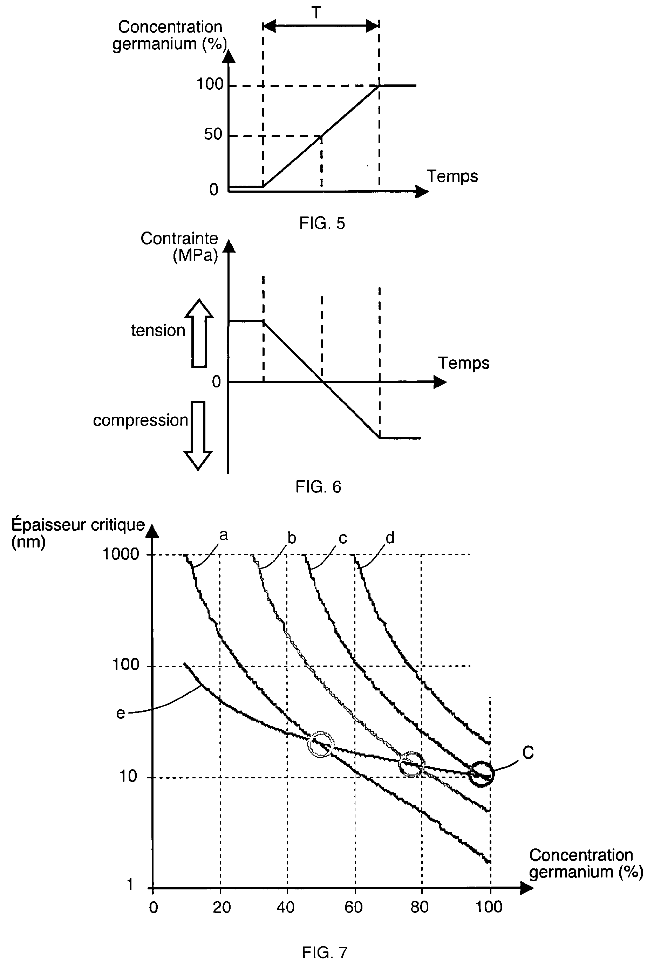

La figure 7 est un graphique de l'épaisseur critique de relaxation plastique d'un alliage de silicium et germanium déposé sur un substrat en silicium ou silicium sur isolant non contraint (courbe a), en silicium sur isolant contraint à 20% (courbe b), c'est-à-dire avec un paramètre de maille de surface identique au paramètre de maille d'un alliage de silicium et germanium comportant 20% de germanium, en silicium sur isolant contraint à 35% (courbe c), en silicium sur isolant contraint à 50% (courbe d), la courbe e représentant l'évolution de la concentration et de l'épaisseur de la couche enrichie en germanium en fonction de l'enrichissement.

### Description de modes particuliers de réalisation

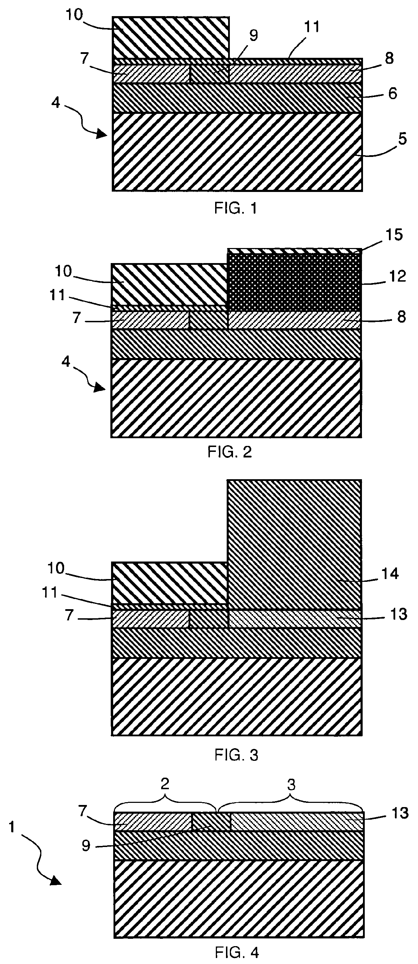

En référence aux figures 1 à 6, le procédé de fabrication selon l'invention est destiné notamment à réaliser un substrat 1 mixte, c'est-à-dire présentant au moins une portion 2 en silicium sur isolant contraint en tension (sSOl), co-intégrée avec au moins une portion 3 en germanium sur isolant contraint en compression (sGeOl) (figure 4). Un tel substrat 1 est plus particulièrement destiné à être utilisé pour la réalisation de circuits CMOS (« Complementary Metal Oxide Semiconductor » en anglais), la portion 2 en silicium sur isolant contraint en tension étant destinée à la réalisation de composants, par exemple un transistor, de type N-MOS et la portion 3 en germanium sur isolant contraint en compression étant destinée à la réalisation de composants, par exemple un transistor, de type P-MOS.

Sur les figures 1 à 4, le procédé de réalisation consiste plus particulièrement à utiliser une technique d'enrichissement en germanium localisé, de préférence par un traitement thermique d'oxydation localisé, appliqué sur un substrat en silicium sur isolant contraint sSOl (« strain Silicon On Insulator » en anglais). Sur la figure 1, la première étape du procédé consiste à réaliser un substrat de base 4 en silicium sur isolant contraint (sSOl), présentant une couche 5 en silicium, une couche d'oxyde 6 enterrée et une membrane supérieure, au-dessus de la couche d'oxyde 6, comprenant, de préférence, deux zones 7, 8 en silicium contraint en tension, avantageusement séparées par au moins une zone d'isolation latérale 9.

La première zone 7 en silicium contraint en tension (figure 1) du substrat de base 4 forme la portion 2 en silicium sur isolant contraint du substrat 1 (figure 4), sur laquelle au moins un composant N-MOS est destiné à être réalisé. La seconde zone 8 en silicium contraint en tension du substrat de base 4 est destinée à être transformée, pour obtenir la portion 3 en germanium sur isolant contraint en compression, sur laquelle au moins un composant P-MOS est destiné à être réalisé.

Dans le mode particulier de réalisation du procédé représenté sur les figures 1 à 4, le substrat de base 4 en silicium sur isolant contraint en tension est obtenu, par exemple, à partir d'une couche en alliage de silicium et germanium Si_{1-Y}Ge_{Y}, avec une concentration Y de germanium comprise avantageusement entre 20% et 60%, de préférence de l'ordre de 50% (figure 5). Chaque zone 7, 8 en silicium formant la membrane supérieure du substrat de base 4 est ainsi contrainte en tension, c'est-à-dire que le paramètre de maille du silicium est modifié et équivaut au paramètre de maille de la surface de la couche en alliage de silicium et germanium Si_{1-Y}Ge_{Y} ayant servi à fabriquer le substrat de base 4. Classiquement, les zones 7, 8 en silicium et l'alliage de silicium et germanium ont, dans un plan parallèle au substrat 4, le même paramètre de maille qui est appelé le paramètre de maille de la surface.

Sur la figure 1, après la réalisation du substrat de base 4 en silicium sur isolant contraint, le procédé de fabrication comporte une étape de masquage de la première zone 7 en silicium contraint en tension. L'étape de masquage est réalisée, par exemple, par dépôt et structuration d'une couche 10 imperméable à l'oxygène, autrement dit non réactive à l'oxygène, et résistante au budget thermique d'une étape d'oxydation d'un procédé d'enrichissement en germanium. À titre d'exemple, la couche 10 de masquage est en nitrure de silicium.

Dans le mode particulier de réalisation représenté sur les figures 1 à 4, le procédé de fabrication comporte avantageusement, avant l'étape de masquage ci-dessus, le dépôt d'une couche 11 d'arrêt de gravure, par exemple en oxyde de silicium, destinée notamment à stopper les différentes gravures effectuées en fin de procédé, nécessaires à l'obtention du substrat 1 final, comme représenté sur la figure 4.

Sur la figure 2, l'étape suivante du procédé consiste à effectuer une transformation de la zone 8 en silicium contraint en tension par une technique d'enrichissement en germanium, plus particulièrement un traitement thermique d'oxydation, localisé uniquement sur la zone 8 en silicium contraint en tension. De manière classique, un tel procédé de d'enrichissement en germanium par traitement d'oxydation thermique comporte d'abord le dépôt, par exemple par épitaxie sélective, d'une couche 12 en alliage de silicium et germanium Si_{1-X}Ge_{X} sur la zone 8 en silicium contraint en tension, non masquée par la couche 10 en nitrure de silicium.

Dans le mode particulier de réalisation de la figure 2, le procédé comporte avantageusement une étape de dépôt d'une couche additionnelle 15 de silicium, formée au-dessus de la couche 12 en alliage de silicium et germanium Si_{1-X}Ge_{X}. La couche additionnelle 15 de silicium est monocristalline, avec une épaisseur, par exemple, de l'ordre de quelques angstrôms à quelques nanomètres. La couche additionnelle 15 sert notamment à former une fine couche d'oxyde de silicium SiO₂ sur le dessus de la zone localisée du substrat de base 4, empêchant la consommation de germanium lors de l'étape d'oxydation thermique du procédé d'enrichissement en germanium, dans le cas d'un enrichissement en germanium par traitement d'oxydation thermique.

Sur la figure 3, le procédé de fabrication comporte ensuite l'enrichissement en germanium de la couche 12 ainsi déposée, par traitement d'oxydation thermique, jusqu'à obtenir une couche 13 en germanium contraint en compression, surmontée par une couche 14 en oxyde de silicium.

Par ailleurs, comme représenté plus particulièrement sur les figures 5 et 6 illustrant, respectivement, l'évolution de la concentration en germanium en fonction du temps et l'évolution de la contrainte correspondante en fonction du temps, au cours de la durée T du procédé d'enrichissement en germanium de la couche 12 en alliage de silicium et germanium Si_{1-X}Ge_{X}, celle-ci passe d'une contrainte en tension à une contrainte en compression (figure 6).

Sur la figure 5, tant que la concentration X de germanium de la couche 12 est inférieure à la concentration Y correspondant à la contrainte de la zone 8 en silicium du substrat de base 4, à savoir 50% dans le mode particulier de réalisation représenté sur la figure 5, la couche 12 en alliage de silicium et germanium Si_{1-X}Ge_{X} est contrainte en tension (figure 6). Quand la concentration X de la couche 12 devient supérieure à la concentration Y, à savoir 50% dans le mode particulier de réalisation représenté sur la figure 5, alors la couche 12 en alliage de silicium et germanium Si_{1-X}Ge_{X} est contrainte en compression, ce qui permet d'obtenir une couche 13 en germanium contraint en compression, à la fin du procédé d'enrichissement en germanium.

Par ailleurs, sur les figures 5 et 6, quand les concentrations 1-X et 1-Y sont égales, la couche 12 en alliage de silicium et germanium S_{1-X}Ge_{X} passe alors par un état non contraint mécaniquement, c'est-à-dire que la couche 12 est non contrainte.

Sur la figure 4, la dernière étape du procédé consiste enfin à éliminer, de préférence par gravure, à la fois la couche 14 d'oxyde de silicium, issue du procédé d'enrichissement en germanium décrit ci-dessus, dans le cas d'un enrichissement en germanium par traitement d'oxydation thermique, et également la couche 10 en nitrure de silicium, faisant office de masque. Le substrat 1 ainsi obtenu est donc un substrat mixte en silicium sur isolant contraint en tension (sSOl), avec une couche 7 en silicium contraint en tension, et en germanium sur isolant contraint en compression (sGeOl), avec une couche 13 en germanium contraint en compression. Le substrat 1 ainsi obtenu est alors approprié plus particulièrement à la réalisation de circuits CMOS, avec des composants N-MOS réalisés sur la couche 7 en silicium contraint en tension et des composants P-MOS réalisés sur la couche 13 en germanium contraint en compression.

Un tel procédé de fabrication d'un substrat 1 mixte, comme décrit ci-dessus, présente donc l'avantage, notamment, de n'avoir pas ou peu de défaut structuraux, notamment grâce à l'utilisation d'un substrat de base 4 en silicium sur isolant contraint.

En effet, la figure 7 décrit le cas particulier d'un substrat de départ 4 avec une couche en alliage de silicium et germanium Si_{1-X}Ge_{X}, avec la concentration X de germanium égale à 0,1 et une épaisseur de la couche de 100nm. Plus particulièrement, la figure 7 représente l'épaisseur critique de relaxation plastique théorique d'un alliage de silicium et germanium Si_{1-X}Ge_{X}, déposé sur un substrat en silicium ou en silicium sur isolant non contraint (courbe a), en silicium sur isolant contraint à 20% (courbe b), c'est-à-dire présentant un paramètre de maille de surface identique au paramètre de maille d'un alliage de silicium et germanium SiGe comportant 20% de germanium, en silicium sur isolant contraint à 35% (courbe c) et en silicium sur isolant contraint à 50% (courbe d). La courbe e représente l'évolution de la concentration et de l'épaisseur de la couche enrichie en germanium en fonction de l'enrichissement, c'est-à-dire illustrant la conservation de la quantité de germanium lors du procédé d'enrichissement, à savoir 10% de germanium sur la figure 7 et une épaisseur de couche de 100nm.

Il ressort ainsi de la figure 7 que, pour les courbes a à c, il apparaît des dislocations dans le substrat dues à la relaxation des contraintes, dès que la courbe e croise les courbes a à c, c'est-à-dire au niveau des cercles C représentés sur la figure 7. Pour la courbe d, aucune relaxation des contraintes n'est observée, car il n'y a pas d'intersection entre la courbe d et la courbe e. Il est ainsi possible d'obtenir un enrichissement jusqu'à 100%, sans relaxation des contraintes.

Il ressort ainsi de la figure 7 que plus le substrat de base 4 en silicium sur isolant est contraint, plus la limite de relaxation, à savoir l'intersection avec la courbe e sur la figure 7, est repoussée et plus elle s'approche de 100%. Cette valeur est notamment atteinte pour un substrat en silicium sur isolant ayant une contrainte équivalente à une hétéroépitaxie de silicium sur une couche en alliage de silicium avec environ 40% de germanium et pour un substrat de base 4 comportant une couche en alliage de silicium et germanium de 100nm d'épaisseur et avec 10% de germanium. Il en résulte donc que l'utilisation d'un tel substrat de base 4 en silicium sur isolant contraint permet d'obtenir un substrat 1 avec une couche de germanium sur isolant pouvant atteindre 10nm d'épaisseur, sans relaxation des contraintes et donc sans apparition de dislocations.

Par ailleurs, le substrat 1 mixte obtenu par le procédé selon l'invention présente des caractéristiques optimales d'un point de vue matériaux constitutifs, notamment grâce à l'absence de défauts dûs à la relaxation des contraintes, permettant d'optimiser la réalisation des composants N-MOS et P-MOS. Le procédé de fabrication permet ainsi de réduire au maximum le taux de défauts et permet de conserver la contrainte mécanique, tant dans la portion en silicium sur isolant que dans la portion en germanium sur isolant au cours de l'enrichissement, sans qu'il n'y ait relaxation mécanique des contraintes.

Par ailleurs, le substrat 1 mixte obtenu par le procédé selon l'invention présente une surface supérieure sensiblement plane, ce qui permet de réaliser des composants N-MOS et P-MOS coplanaires. Il en résulte une optimisation des caractéristiques du circuit CMOS associé.

Dans une variante de réalisation non représentée, dans laquelle la surface supérieure du substrat 1 ainsi obtenu ne serait pas totalement plane, il est possible de réaliser une étape additionnelle de reprise d'épitaxie sur la portion 3 en germanium sur isolant contraint en compression ou sur la portion 2 en silicium sur isolant contraint en tension. D'une façon générale, la couche la plus fine, qu'elle soit en silicium ou en germanium, peut être épaissie par homoépitaxie. Il est ainsi possible d'obtenir un substrat 1 avec une surface supérieure parfaitement plane, ce qui est très intéressant notamment d'un point de vue outils de lithographie, qui présentent des profondeurs de champ de plus en plus faibles au cours du temps.

L'invention n'est pas limitée aux différents modes de réalisation décrits ci-dessus. Le substrat de base 4 en silicium sur isolant contraint peut être réalisé par toute technique de fabrication connue et peut comporter une pluralité de zones en silicium contraint en tension et une pluralité de zones d'isolation latérale. La couche 10 de masquage peut être en tout autre matériaux.

La portion 3 en germanium sur isolant contraint en compression du substrat 1 peut être obtenu notamment par tout type de procédé d'enrichissement en germanium. En particulier, la portion 3 en germanium sur isolant peut être obtenue par un procédé d'enrichissement par siliciuration sélective, comme décrit dans la demande de brevet n° 07 53146 du 8 février 2007. Un tel procédé consiste notamment à réaliser une étape de dépôt sur une couche en alliage de silicium et germanium d'une couche d'un élément métallique, apte à former sélectivement un siliciure, puis à effectuer une étape de réaction, par exemple un recuit ou un traitement d'oxydation, entre ladite couche en alliage de silicium et germanium et ladite couche d'un élément métallique. De telles étapes permettent alors d'obtenir une superposition de couches de siliciure de métal et de germanium sur isolant, l'élimination de la couche de siliciure permettant alors d'obtenir la portion 3 en germanium sur isolant contraint en compression.

La réalisation des zones 9 d'isolation latérales peut être effectuée avant ou après l'étape d'enrichissement en germanium.

Le substrat 1 obtenu par un tel procédé de fabrication peut être notamment utilisé pour tout autre application nécessitant un substrat mixte présentant une portion en silicium sur isolant contraint en tension et une portion en germanium sur isolant contraint en compression.

## Revendications

1. Procédé de fabrication d'un substrat (1) mixte comportant au moins une portion (2) en silicium sur isolant contraint en tension et au moins une portion (3) en germanium sur isolant contraint en compression, le procédé comportant une première étape de réalisation d'un substrat de base (4) en silicium sur isolant contraint, comportant au moins des première (7) et seconde (8) zones en silicium contraint en tension, le procédé comporte, après la réalisation du substrat de base (4) en silicium sur isolant contraint, les étapes successives suivantes de:
- masquage de la première zone (7) en silicium contraint en tension du substrat de base (4), formant la portion (2) en silicium sur isolant contraint en tension du substrat (1),
- traitement d'enrichissement en germanium de la seconde zone (8) en silicium contraint en tension du substrat de base (4), jusqu'à obtenir ladite portion (3) en germanium sur isolant contraint en compression du substrat (1),
- élimination du masquage.

2. Procédé selon la revendication 1, **caractérisé en ce que** l'étape de traitement d'enrichissement en germanium comporte une étape de traitement d'oxydation thermique.

3. Procédé selon la revendication 2, **caractérisé en ce que** l'étape de masquage est réalisée par dépôt et structuration d'une couche (10) en matériau non réactif à l'oxygène.

4. Procédé selon la revendication 3, **caractérisé en ce que** ladite couche (10) en matériau non réactif à l'oxygène est en nitrure de silicium.

5. Procédé selon l'une quelconque des revendications 2 à 4, **caractérisé en ce que** l'étape de traitement d'oxydation thermique comporte une étape de dépôt d'une couche (12) en alliage de silicium et germanium, suivie d'une étape de dépôt d'une couche additionnelle (15) en silicium.

6. Procédé selon la revendication 1, **caractérisé en ce que** l'étape de traitement d'enrichissement en germanium comporte une étape de traitement d'enrichissement par siliciuration sélective.

7. Procédé selon l'une quelconque des revendications 1 à 6, **caractérisé en ce qu'**il comporte le dépôt d'une couche (11) d'arrêt de gravure sur le substrat de base (4), avant l'étape de masquage.

8. Procédé selon la revendication 7, **caractérisé en ce que** la couche (11) d'arrêt de gravure est une couche d'oxyde.

9. Procédé selon l'une quelconque des revendications 1 à 8, **caractérisé en ce que** le substrat de base (4) en silicium sur isolant contraint comporte au moins une zone d'isolation latérale (9), formée entre les première (7) et seconde (8) zones en silicium contraint en tension, avant l'étape de masquage.

10. Procédé selon l'une quelconque des revendications 1 à 8, **caractérisé en ce que** le substrat de base (4) en silicium sur isolant contraint comporte au moins une zone d'isolation latérale (9), formée entre la portion (2) en silicium sur isolant contraint en tension et la portion (3) en germanium sur isolant contraint en compression, après l'étape d'élimination du masquage.

11. Procédé selon l'une quelconque des revendications 1 à 10, **caractérisé en ce qu'**il comporte une étape de reprise d'épitaxie, sur la portion (3) en germanium sur isolant contraint en compression ou sur la portion (2) en silicium sur isolant contraint en tension.

12. Utilisation d'un substrat (1) obtenu par le procédé de fabrication selon l'une quelconque des revendications 1 à 11, pour la réalisation de circuits CMOS comportant au moins un composant N-MOS réalisé sur la portion (2) en silicium sur isolant contraint en tension du substrat (1) et au moins un composant P-MOS réalisé sur la portion (3) en germanium sur isolant contraint en compression du substrat (1).

## Patentansprüche

1. Verfahren zur Herstellung eines Mischsubstrats (1), das wenigstens einen zugbeanspruchten Silizium-auf-Isolator-Abschnitt (2) und wenigstens einen druckbeanspruchten Germanium-auf-Isolator-Abschnitt (3) umfasst, wobei das Verfahren einen ersten Schritt zur Ausbildung eines gespannten Silizium-auf-Isolator-Basissubstrats (4) mit wenigstens einem ersten (7) und einem zweiten (8) zugbeanspruchten Silizium-Bereich umfasst,
das Verfahren umfasst nach der Ausbildung des gespannten Silizium-auf-Isolator-Basissubstrats (4) die folgenden aufeinander folgenden Schritte:
- des Maskierens des ersten zugbeanspruchten Silizium-Bereichs (7) des Basissubstrats (4), welcher den zugbeanspruchten Silizium-auf-Isolator-Abschnitt (2) des Substrats (1) bildet,
- der Behandlung zur Germaniumanreicherung des zweiten zugbeanspruchten Silizium-Bereichs (8) des Basissubstrats (4), bis der druckbeanspruchte Germaniumauf-Isolator-Abschnitt (3) des Substrats (1) erhalten ist,
- des Entfernens der Maskierung.

2. Verfahren nach Anspruch 1, **dadurch gekennzeichnet, dass** der Schritt der Behandlung zur Germaniumanreicherung einen Schritt einer Oxidationswärmebehandlung umfasst.

3. Verfahren nach Anspruch 2, **dadurch gekennzeichnet, dass** der Schritt des Maskierens durch Abscheiden und Strukturieren einer Schicht (10) aus nicht sauerstoffreaktivem Material vollzogen wird.

4. Verfahren nach Anspruch 3, **dadurch gekennzeichnet, dass** die Schicht (10) aus nicht sauerstoffreaktivem Material aus Siliziumnitrid besteht.

5. Verfahren nach einem der Ansprüche 2 bis 4, **dadurch gekennzeichnet, dass** der Schritt der Oxidationswärmebehandlung einen Schritt zum Abscheiden einer Schicht (12) aus Silizium-Germanium-Legierung umfasst, an den sich ein Schritt zum Abscheiden einer zusätzlichen Schicht (15) aus Silizium anschließt.

6. Verfahren nach Anspruch 1, **dadurch gekennzeichnet, dass** der Schritt der Behandlung zur Germaniumanreicherung einen Schritt einer Behandlung zur Anreicherung durch selektives Silizidieren umfasst.

7. Verfahren nach einem der Ansprüche 1 bis 6, **dadurch gekennzeichnet, dass** es vor dem Maskierungsschritt die Abscheidung einer Ätzsperrschicht (11) auf dem Basissubstrat (4) umfasst.

8. Verfahren nach Anspruch 7, **dadurch gekennzeichnet, dass** die Ätzsperrschicht (11) eine Oxidschicht ist.

9. Verfahren nach einem der Ansprüche 1 bis 8, **dadurch gekennzeichnet, dass** das gespannte Silizium-auf-Isolator-Basissubstrat (4) wenigstens einen seitlichen Isolationsbereich (9) umfasst, der vor dem Maskierungsschritt zwischen dem ersten (7) und dem zweiten (8) zugbeanspruchten Silizium-Bereich ausgebildet wird.

10. Verfahren nach einem der Ansprüche 1 bis 8, **dadurch gekennzeichnet, dass** das gespannte Silizium-auf-Isolator-Basissubstrat (4) wenigstens einen seitlichen Isolationsbereich (9) umfasst, der nach dem Schritt des Entfernens der Maskierung zwischen dem zugbeanspruchten Silizium-auf-Isolator-Abschnitt (2) und dem druckbeanspruchten Germanium-auf-Isolator-Abschnitt (3) ausgebildet wird.

11. Verfahren nach einem der Ansprüche 1 bis 10, **dadurch gekennzeichnet, dass** es einen Schritt einer erneuten Epitaxie auf dem druckbeanspruchten Germanium-auf-Isolator-Abschnitt (3) oder auf dem zugbeanspruchten Silizium-auf-Isolator-Abschnitt (2) umfasst.

12. Verwendung eines durch das Herstellungsverfahren nach einem der Ansprüche 1 bis 11 erhaltenen Substrats (1) für die Herstellung von CMOS-Schaltkreisen, die wenigstens ein N-MOS-Bauelement, das auf dem zugbeanspruchten Silizium-auf-Isolator-Abschnitt (2) des Substrats (1) ausgebildet ist, und wenigstens ein P-MOS-Bauelement, das auf dem druckbeanspruchten Germanium-auf-Isolator-Abschnitt (3) des Substrats (1) ausgebildet ist, umfassen.

## Claims

1. A fabrication method of a mixed substrate comprising at least one tensile strained silicon-on-insulator portion (2) and at least one compressive strained germanium-on-insulator portion (3), the method comprising a first step of producing a strained silicon-on-insulator base substrate (4) comprising at least first (7) and second (8) tensile strained silicon zones,
the method comprises, after the strained silicon-on-insulator base substrate (4) has been produced, the following successive steps of:
- masking the first tensile strained silicon zone of the base substrate (4) forming the tensile strained silicon-on-insulator portion (2) of the substrate (1),
- germanium enrichment treatment of the second tensile strained silicon zone (8) of the base substrate (4) until said compressive strained germanium-on-insulator portion (3) of the substrate (1) is obtained,
- removal of the masking.

2. The method according to claim 1, **characterized in that** the germanium enrichment treatment step comprises a thermal oxidation treatment step.

3. The method according to claim 2, **characterized in that** the masking step is performed by deposition and patterning of a layer (10) made from a material that is non-reactive to oxygen.

4. The method according to claim 3, **characterized in that** said layer (10) of non-reactive to oxygen material is made from silicon nitride.

5. The method according to anyone of the claims 2 to 4, **characterized in that** the thermal oxidation treatment step comprises a deposition step of a silicon and germanium alloy layer (12) followed by a deposition step of an additional silicon layer (15).

6. The method according to claim 1, **characterized in that** the germanium enrichment treatment step comprises a selective silicidation enrichment treatment step.

7. The method according to anyone of the claims 1 to 6, **characterized in that** it comprises deposition of an etch stop layer (11) on the base substrate (4) before the masking step.

8. The method according to claim 7, **characterized in that** the etch stop layer (11) is an oxide layer.

9. The method according to anyone of the claims 1 to 8, **characterized in that** the strained silicon-on-insulator base substrate (4) comprises at least one lateral insulation zone (9) formed between the first (7) and second (8) tensile strained silicon zones before the masking step.

10. The method according to anyone of the claims 1 to 8, **characterized in that** the strained silicon-on-insulator base substrate (4) comprises at least one lateral insulation zone (9) formed between the tensile strained silicon-on-insulator portion (2) and the compressive strained germanium-on-insulator portion (3) after the masking removal step.

11. The method according to anyone of the claims 1 to 10, **characterized in that** it comprises an epitaxy deposition step on the compressive strained germanium-on-insulator portion (3) or on the tensile strained silicon-on-insulator portion (2).

12. The use of a substrate (1) obtained by the fabrication method according to anyone of the claims 1 to 11 for producing CMOS circuits comprising at least one N-MOS component produced on the tensile strained silicon-on-insulator portion (2) of the substrate (1) and at least one P-MOS component produced on the compressive strained germanium-on-insulator portion (3) of the substrate (1).
